# EUROPEAN PATENT SPECIFICATION

(11) **EP 1 217 647 B1**
(45) Date of publication and mention of the grant of the patent: **08.03.2006**
(21) Application number: 00311559.9
(22) Date of filing: 21.12.2000
(51) Int. Cl.: H01L 21/00

(54) **Substrate loading apparatus**
Substrateneinschleusenvorrichtung
Dispositif de chargement de substrats

(43) Date of publication of application: 26.06.2002
(73) Proprietor: Oxford Instruments Plasma Technology Limited, Witney, Oxfordshire OX8 1TL (GB); Universität Gesamthochschule Kassel, 34132 Kassel (DE)
(72) Inventor: Croad, Roger J. W., Somerset, TA6 7HX (GB); Goodyear, Andrew L., North Somerset, BS21 7XA (GB); Rangelow, Ivaylo W., 34255 Baunatal 4 (DE); Volland, Burkhard, 34134 Kassel (DE)
(74) Representative: Skone James, Robert Edmund

(56) References cited:
- FR-A- 2 569 168
- US-A- 4 715 921
- US-A- 4 971 512
- US-A- 6 062 852
- PATENT ABSTRACTS OF JAPAN vol. 017, no. 203 (E-1354), 21 April 1993 (1993-04-21) & JP 04 346247 A (FUJITSU LTD), 2 December 1992 (1992-12-02)
- PATENT ABSTRACTS OF JAPAN vol. 1996, no. 06, 28 June 1996 (1996-06-28) & JP 08 055814 A (NISSIN HIGH VOLTAGE CO LTD), 27 February 1996 (1996-02-27)

## Description

The present invention relates to apparatus for loading a substrate onto a processing surface in a thin-film processing chamber.

Thin-film processing chambers are used for processing substrates, such as silicon wafers, by either etching the substrate or depositing additional material onto the substrate. Such processing chambers include a processing surface onto which the substrate must be loaded before processing. These substrates are generally very delicate in nature and it is therefore important that the loading procedure does not subject the substrate to undue levels of stress which result in the substrate becoming damaged.

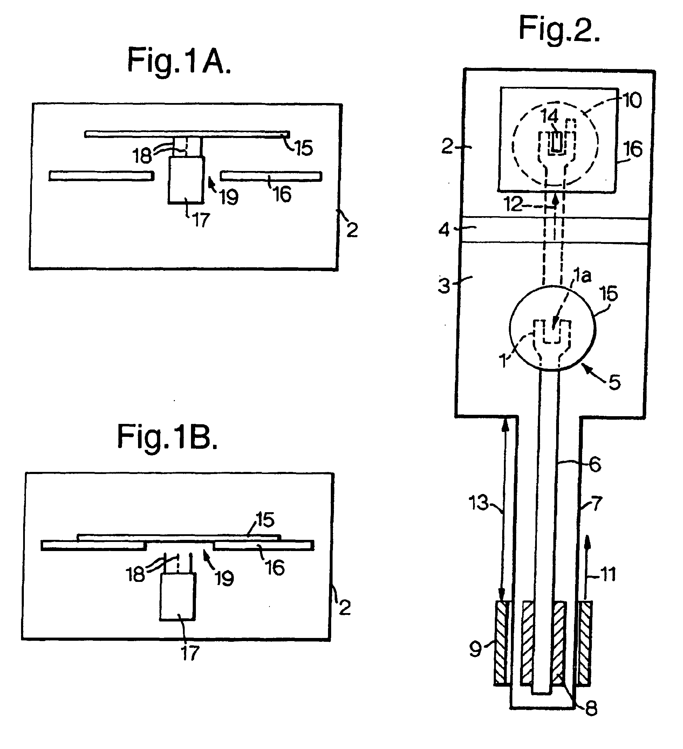

One example of loading apparatus that has previously been used is shown in Figure 1A. This comprises of a processing chamber 2 including a support 17 which projects through an aperture 19 of a processing surface 16. The support 17 includes three arms 18 which extend vertically upwards from the support 17 so as to contact the underside of a substrate 15, as shown. In use, once the substrate 15 is positioned on top of the arms 18 the support 17 is lowered to the position shown in Figure 1B so that the substrate 15 is lowered on to the processing surface 16.

In general, whilst the substrate 15 may be placed on the arms 18 by hand, a loading arm is preferably used to aid the loading procedure. An example of such a suitable loading arm system is shown in Figure 2.

In this case, the processing chamber is coupled to a loading chamber 3 via a valve 4. Before loading commences, the substrate 15 is manually loaded onto a substrate holder 1. The loading chamber 2 is then evacuated so it is at the same pressure as the processing chamber 2 and the valve 4 is opened.

The substrate holder 1 is fixed to a distal end 5 of a loading arm 6. The arm 6 extends from the rear of the loading chamber 3 into a loading arm chamber 7 (also evacuated). The rear end of the loading arm chamber 7 is fitted with a suitable magnetic material 8 which is attracted to a cylindrical magnetic slider 9 which is slidably mounted to the exterior of the loading arm chamber 7. The substrate holder 1 is then transferred into the processing chamber 2 by manually sliding the magnetic slider 9 as indicated at 11.

This causes the loading arm 6 to move with the slider 9, consequently causing the substrate holder 1 to move into the loading position as indicated by dotted lines at 10. The distance of travel 12 of the substrate holder 9 is limited by the allowable extent of travel 13 of the slider 9.

Once the loading arm 6 is positioned in the processing chamber 2, the support 17 is raised from the retracted position shown in Figure 1B. As shown in Figure 2, the substrate holder 1 includes a recess la which is configured such that as the support is raised, the arms 18 pass through the recess 1a and engage the underside of the substrate 15. This action raises the substrate 15 clear of the substrate holder 1 such that the loading arm 6 may be removed from the processing chamber, whilst the substrate 15 remains supported by the arms 18. The support 17 is then lowered to the position shown in Figure 1B to leave the substrate 15 in contact with the processing surface 16.

Unfortunately, such a system has the disadvantage that the arms 18 contact the lower surface of the substrate 15. As mentioned above, the substrates are particularly delicate and this operation can therefore cause significant damage to the substrate.

US-A-6062852, which discloses the preamble of claim 1 of the present application, discloses a substrate heat-treating apparatus including a heat-treating plate, and support pins extending through the heat-treating plate to be vertically movable relative thereto. The support pins support each substrate at a lower surface thereof such that edges of the substrate are at a higher level than a central region of the substrate.

In accordance with the present invention, we provide a processing chamber with a processing surface and an apparatus for loading a substrate onto the processing surface, the apparatus comprising a support which cooperates with one or more corresponding apertures in the processing surface so as to be movable between an extended position in which the support can support a substrate above the processing surface, and a retracted position in which the support is located within said one or more apertures and flush with or located below the processing surface, wherein the support comprises a number of limbs extending radially outwardly from a central hub, characterized in that said limbs extend radially outward at an angle relative to the processing surface, the limbs being configured to contact the edges of different sized substrates in use so as to support the substrate in a support plane substantially parallel to the processing surface, the support plane being provided above the central hub.

Accordingly, the present invention provides a processing chamber with an apparatus for loading a substrate onto a processing surface which does not contact the lower surface of the substrate. Instead, the limbs of the support are designed to contact the edges of the substrate whilst supporting the substrate substantially parallel to the processing surface. The support can then be lowered allowing the substrate to be gently placed on the processing surface. Furthermore, by having the limbs extend at angle offset to the processing surface, the limbs can be used to support any size of substrate.

Typically each end defines a continuous support surface extending at an angle relative to the processing surface, each support surface contacting the edges of different size substrates in use. The use of he angled support surface allows a simple construction to be used which can support any size of substrate and allow this to be easily loaded onto the processing surface. Alternatively however each limb may define a number of support surfaces, with each support surface being associated with a respective support plane. In this configuration, the limb will effectively consist of a number of steps with the corresponding steps of each limb being configured to accept a different size of substrate. This again allows different sizes of substrate to be easily loaded on to the processing surface.

Typically the processing chamber further comprises a loading arm having a mounting which receives a substrate in use, the loading arm being movable between the retracted position and an extended position in which the mounting and support cooperates such that, in use, motion of the support to the extended position causes the substrate to be supported by the support, thereby removing the substrate from the mounting. As will already be realised, this provides apparatus having a simple construction which allows the substrate to be automatically loaded onto the processing surface within the processing chamber. However, any suitable means for placing the substrate on to the support, such as hand loading, or the use of a robotic arm, may be used. In the case in which a robotic arm is used, the robotic arm is typically arranged with a number of processing chambers circumferentially spaced around it, thereby allowing the arm to be used to load substrates into a number of different processing chambers in turn.

Typically the mounting comprises a number of mounting elements extending radially outward from a central portion, each mounting element including a number of steps defining a number of mounting surfaces and each mounting surface being associated with a respective mounting plane. In this configuration, each mounting element will effectively consist of a number of steps, with each step defining a mounting surface. The corresponding mounting surfaces of each limb are then configured to accept a different size of substrate so that a separate mounting position is defined for each different size of substrate that is to be used. In use, the substrate is positioned on the steps defined by the mounting surfaces, thereby ensuring that the substrate is in the optimum position for subsequent processing. It will however be realised that alternative designs could be used.

The processing chamber may further comprise a drive means for controllably moving the loading arm between the extended or retracted positions. Alternatively however the loading arm may be simply moved by hand.

Typically, the processing chamber further comprises an actuator for controllably moving the support between the extended and retracted positions. This advantageously allows the substrate to be gently lowered onto the processing surface to thereby further reduce the risk of damage to the substrate.

Preferably the processing chamber further comprises a clamp movable between an open position and a clamping position for clamping the substrate to the processing surface. This allows the substrate to be held in position whilst processing occurs. It will however be realised that this will not be essential in all circumstances.

Typically the clamp comprises an annular clamping element extending radially inwardly from an outer clamping ring the clamping ring being positioned radially outwardly from the processing surface. This allows the clamp to be configured to only touch the outer edge of the substrate, thereby reducing the amount of damage that can occur to the substrate, during processing.

The use of an annular clamping element ensures that the substrate is clamped along the entire circumference of its upper surface. This ensures that a strong clamping force can be applied evenly to the substrate thereby ensuring that the substrate is held in place. Furthermore by ensuring that the clamping force is even over the entire surface of the substrate, this helps prevent bending or fracturing of the substrate by the clamping element.

However, if less clamping force is required it is also possible to use a number of separate clamping elements each of which extends radially inwardly from the outer clamping ring. In this case, typically three elements would be provided circumferentially spaced around the annular clamping ring so that the substrate is clamped at three positions around the circumference of its upper surface. This will however generally provide less clamping force and provides an increased risk of fracture during use.

Typically the processing chamber further comprises a clamp actuator for moving the clamp between the open clamping positions, the clamping ring being removably mounted to the clamp actuator. This allows the clamp to be configured to automatically clamp the substrate when it is in position on the processing surface. Furthermore, the clamping ring can be removed from the actuator and replaced with a clamping ring having alternative clamping elements. This allows substrates of different sizes to be suitably clamped to the processing surface.

Typically the processing chamber further comprises a controller for control of the moving support on the loading arm between their respective retracted unextended positions. This allows the substrates to be automatically loaded onto the processing surface, thereby removing the need for operator intervention.

The processing chamber may further comprise a loading arm having a mounting which receives a substrate in use, the loading arm being movable between a retracted position in which the mounting is outside the processing chamber and an extended position in which the mounting is inside the processing chamber, wherein the mounting comprises a number of mounting elements extending substantially radially outwardly from a central position, each mounting element including a number of steps defining a number of mounting surfaces, and wherein the mounting and the support cooperate such that, in use, with the loading arm in the extended position, motion of the support to the extended position causes the substrate to be supported by the support, thereby removing the substrate from the mounting.

Thus, the mounting includes a number of mounting elements each of which defines a number of mounting surfaces by using a stepped arrangement. Each mounting surface is associated with a respective mounting plane and is designed to accept different sizes of substrate. The system is arranged in this configuration so that a separate mounting position is defined for each different size of substrate to be used. Accordingly, by mounting a substrate in the respective mounting plane defined by the appropriate mounting surfaces, this ensures that the substrate is always located in the optimum position for subsequent loading in to the processing chamber and subsequent processing.

With the mounting designed to hold the substrate in the correct position, this ensures that the substrate is correctly loaded onto the processing surface.

Thus, the mounting is adapted so that in use a substrate positioned on the mounting in the respective mounting plane will be located substantially over the centre of the processing surface when the loading assembly is in the extended position.

The processing chamber usually further comprises a drive means for controllably moving the load and between the extended retracted positions.

In this case, the loading arm typically comprises a carriage, first drive means for driving the carriage with respect to a base, a second drive means which moves with the carriage and cooperates with the base whereby the relative movement between the carriage and the base causes the second drive means to drive the mounting with respect to the carriage. However, this is not essential and any suitable loading assembly, such as a loading arm or robotic arm may be used.

When the above mentioned configuration is used the current is slidably mounted to the base and the mounting is slidably mounted to the carriage.

Accordingly, the present invention also provides a thin film processing system comprising one or more such processing chambers.

Examples of the invention will now be described with reference to the accompanying drawings, in which:-
Figure 1A and 1B show apparatus for loading a substrate according to the prior art;
Figure 2 shows a loading arm according to the prior art;
Figure 3 shows a plan view of a first example of a substrate loading apparatus to explain a first embodiment of the invention;
Figure 4 shows a cross section along the line A-A' of the apparatus of Figure 3 in its retracted position;
Figure 5 shows a cross section along the line A-A' of the apparatus of Figure 3 in its extended position;
Figure 6 shows a loading arm, suitable for use with the apparatus of Figure 3, in its retracted position;
Figure 7 shows the arm of Figure 6 in its extended position;
Figure 8 is a cross-section of Figure 6 along a line B-B';
Figure 9 shows a cross section along the line B-B' of the apparatus of Figure 2 in its extended position in conjunction with the loading arm of Figure 6;
Figure 10 shows a plan view of a second example of a substrate loading apparatus to explain a second embodiment of the invention;
Figure 11 shows a cross section along the line C-C' of the apparatus of Figure 9 in its retracted position;
Figure 12 shows the apparatus along the line C-C' of Figure 10 in its extended position;
Figure 13 shows a perspective view of Figure 11;
Figure 14 shows a perspective view of Figure 12;
Figure 15 is a plan view of a processing surface to explain a third embodiment of the present invention;
Figure 16 shows a cross-section along the line D-D' of the processing surface of Figure 15;
Figure 17 is a cross-sectional view of a processing chamber to explain a fourth embodiment of the present invention; and,
Figure 18 shows a perspective cut-away view of the apparatus of Figure 17.

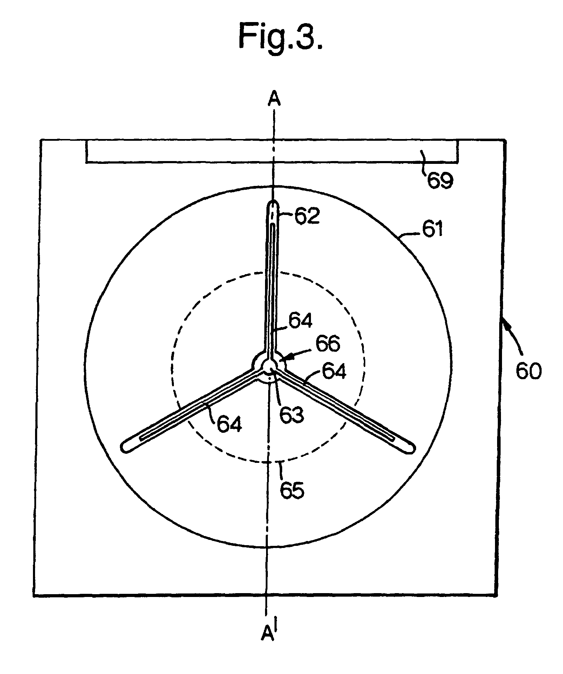

An example of loading apparatus for a processing chamber according to the present invention will now be described with reference to Figures 3 to 5.

Figure 3 shows a plan view of a thin-film processing chamber 60. The chamber 60 includes a processing surface 61 upon which a substrate, indicated by the dotted lines 65, is placed. The processing surface 61 includes an aperture 62 within which is located a substrate support 66. The substrate support 66 is formed from three support limbs 64 which extend radially outwardly from a central hub 63. The processing chamber 60 may optionally also include an interface 69 to allow access to the processing surface 61.

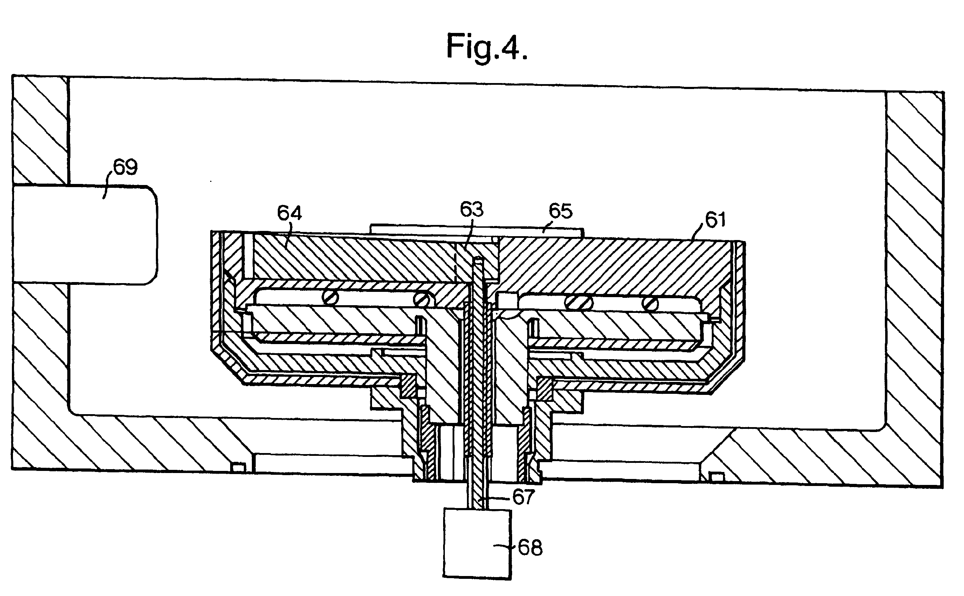

Figure 4 shows a cross-section along the line A-A', when the substrate support 66 is in its retracted position. As shown, the substrate 65 lies on the processing surface 61 with the support limbs 64 being positioned either flush with, or below the processing surface 61. The central hub 63 of the substrate support 66 is coupled via a shaft 67 to an actuator, which is shown schematically at 68.

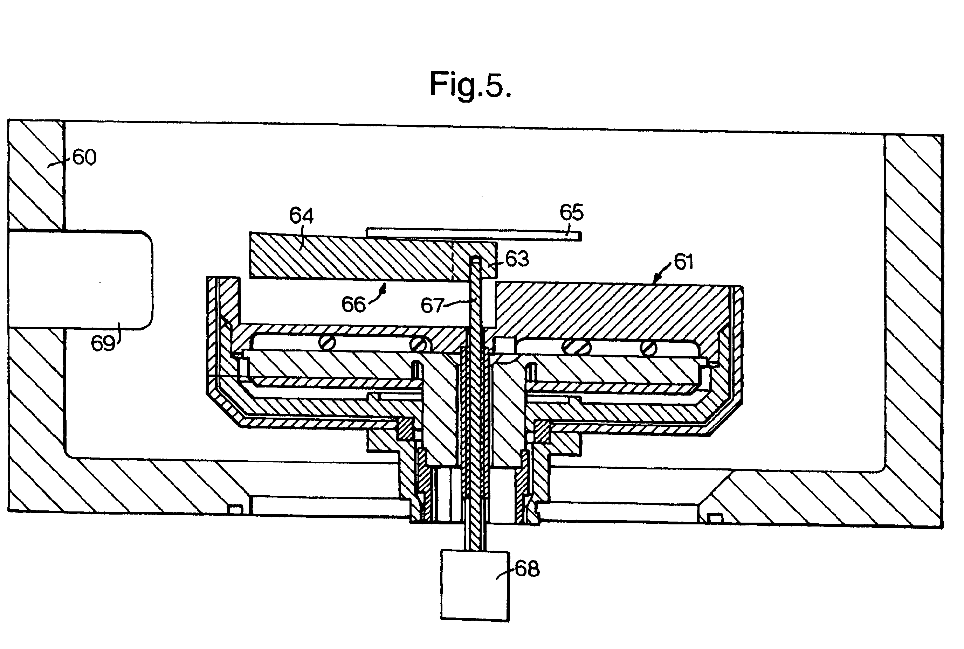

The actuator may be any suitable drive means which can impart vertical motion to the shaft 67. However, preferably it will comprise an air cylinder device coupled to the shaft 67 such that when air is pumped into the cylinder, this will cause the shaft 67, and hence the substrate support 66, to rise into the extended position shown in Figure 5. In this position, the substrate 65 is supported by the support limbs 64.

As shown, the upper surface of the support limbs are provided at an angle with respect to the processing surface 61. Accordingly, the central hub 63 of the substrate support 66 is at a lower height than the outer end of the support limbs 64. As a consequence, the substrate 65 is supported by the edges of the substrate contacting the support limbs 64, as shown. As a result, the central hub 63 is positioned below the substrate 65 and there is no contact of any part of the substrate support 66 with the underside of the substrate 65.

In use, the actuator 68 will initially be actuated to move the substrate support 66 into the extended position. The substrate 65 is then placed on the substrate support 66, as shown in Figure 5. The actuator is then operated to cause the substrate support 66 to gently lower into the retracted position. As a result, the substrate 65 is gently lowered onto the processing surface 61, as shown in Figure 4. It will be realised that such operation ensures that the underside of the substrate 65 is protected from damage as there is no contact with the substrate support 66.

In the above mentioned example, the substrate 65 is positioned on the substrate support 66 by hand. However, it is also possible for a loading arm to be used to load the substrate into the processing chamber. This would generally be achieved by having the loading arm positioned in a loading chamber so as to receive the substrate. The loading arm can then be extended into the processing chamber to position the substrate 65 on the substrate support 66.

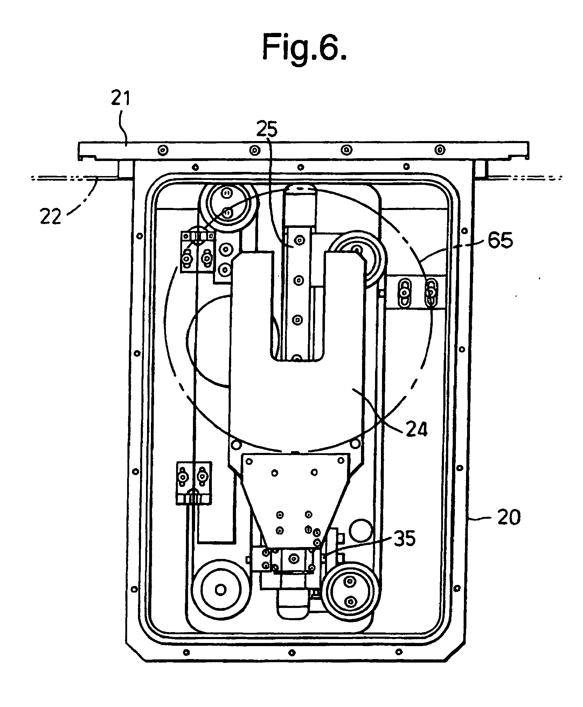

An example of a suitable loading arm will now be described with reference to Figures 6 to 8.

Figure 6 shows a loading arm chamber 20 comprising a standard interface 21 conforming to the SEMI E21-91 standard. This allows the chamber 20 to be mounted in use to any suitable processing chamber interface such as the interface 69 of Figures 3 to 5. Before evacuating the loading chamber 20, a substrate 65 (indicated in dotted lines) such as a wafer is placed on a substrate mounting 24. The position of the clean-room interface when fitted is indicated at 22. The lid of the loading chamber is removed for clarity.

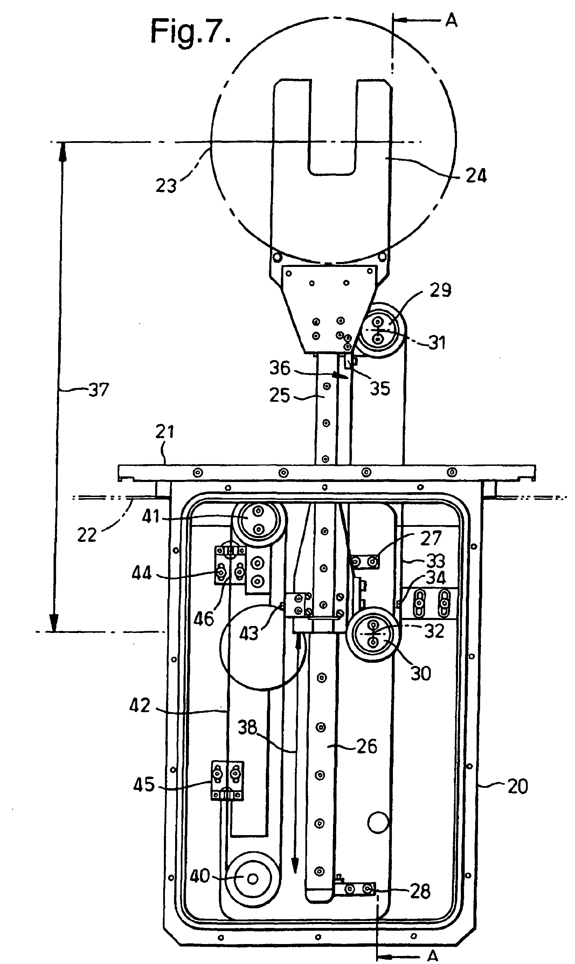

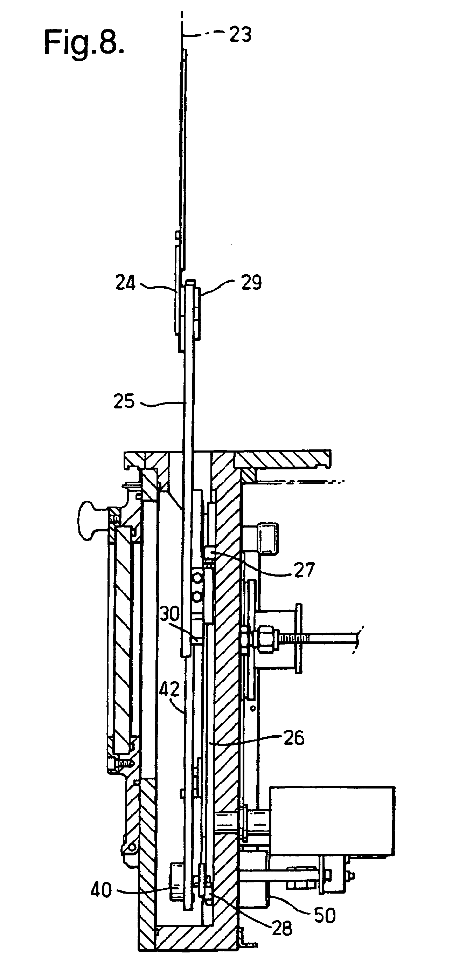

Figure 7 shows a plan view of the loading apparatus in its extended loading position. Figure 8 is a cross-section of Figure 7 along a line A-A. Substrate mounting 24 is slidably mounted on carriage 25 via a conventional linear bearing. Carriage 25 is slidably mounted on fixed rail 26, also via a conventional linear bearing.

Carriage 25 is mounted with pulleys 29, 30 which rotate about axles 31 and 32 respectively. A drive belt comprising a closed loop of steel belt or wire 33 passes round the pulleys 29, 30 and is fixed to the loading chamber 20 at 34, and to the substrate support 24 at 35. Therefore, linear movement of the carriage 25 (and associated pulleys 29,30) in the loading direction causes the pulleys to rotate clockwise (due to the fixing point 34). The combined linear movement of the arm 25, and driven movement of the steel belt or wire 33, causes the lefthand side 36 of the wire loop to move twice the speed and distance of carriage 25. Hence the substrate mounting 24, attached to the lefthand side 36 of the steel belt or wire 33 at fixing point 35 has a transfer distance 37 which is twice the transfer distance 38 of the carriage 25.

The telescopic movement and use of mechanical advantage allows a compact loading chamber. As can be seen from Figure 2, the substrate mounting 24 and carriage 25 have approximately the same length in the loading direction, and in its retracted position the substrate mounting 24 lies in register with the carriage 25. This provides a particularly compact construction.

Carriage 25 is driven by a pulley drive arrangement comprising a first drive pulley 40, a second driven pulley 41 and a closed loop of steel belt or wire 42 which passes round the pulleys 41,40. The steel belt or wire 42 is attached to the arm 25 at 43. Therefore, rotation of the drive pulley 40 in an anti-clockwise direction causes the arm 25 to move in the loading direction. The drive pulley 40 is driven by a drive motor 50 shown in Figure 4. Figure 4 also shows the layered relationship of the slide rail 26, carriage 25 and substrate support 24.

Optical detectors 44,45 detect the presence of a hole 46 in the belt or wire 42 to indicate that the arm 25 has reached its extended or retracted position. In the extended position of Figure 7 the hole has been detected by the detector 44. At this point, the detectors send a signal to motor 50, which causes it to stop rotating the drive pulley 40. If the optical detectors 44,45 fail to work, the extent of movement of carriage 25 is ultimately limited by mechanical stops 27,28.

One or both of the drive belts 33,42 may be mounted vertically, instead of horizontally as shown in Figures 2 to 4.

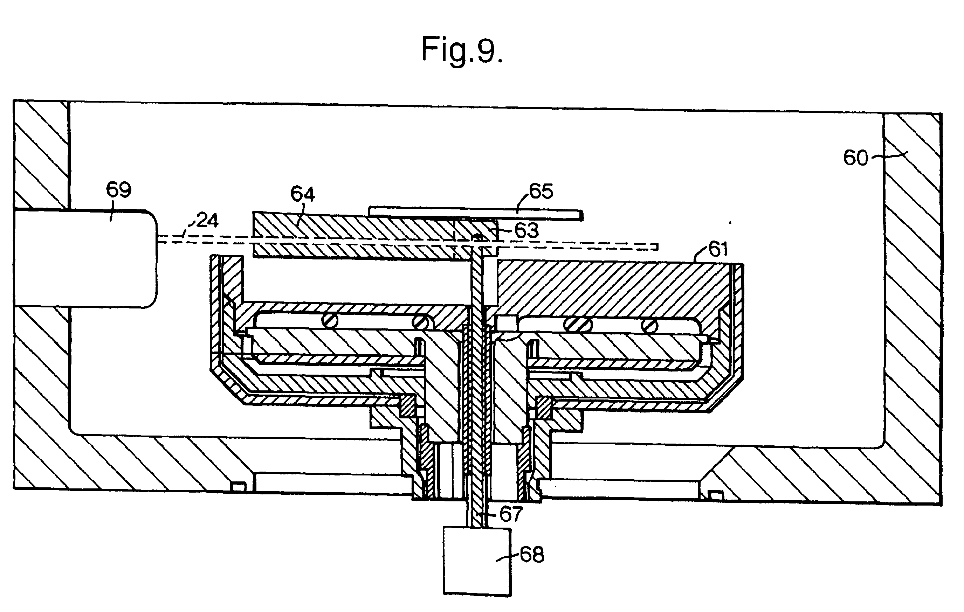

A typical sequence of events in a thin film processing system incorporating the loading assembly according to the invention will now be described with reference to Figure 9.

Before operation, the wafer support is fully retracted into the loading chamber. To load a wafer into the process chamber, the following sequence of events occurs:
1. The operator opens the loading chamber door, places the substrate 65 onto the substrate mounting 24, then closes the load lock door.
2. The loading chamber is pumped down to base pressure.
3. The pneumatically operated interface 69 is opened.
4. The loading arm extends into the processing chamber 60.
5. The substrate 65 is lifted from the substrate mounting 24 by the substrate support 66 to its extended position, as shown in Figure 9. The substrate mounting 24 is withdrawn from the chamber, and the substrate 65 is lowered onto the processing table by the substrate support 66.
6. As the substrate support reaches its fully retracted position within the loading chamber, the hole in steel belt 42 is detected by the photo diode to stop the DC motor 50.
7. The interface 69 is closed and the load lock can be vented if required.

The above sequence of events is repeated to remove the wafer from the processing chamber.

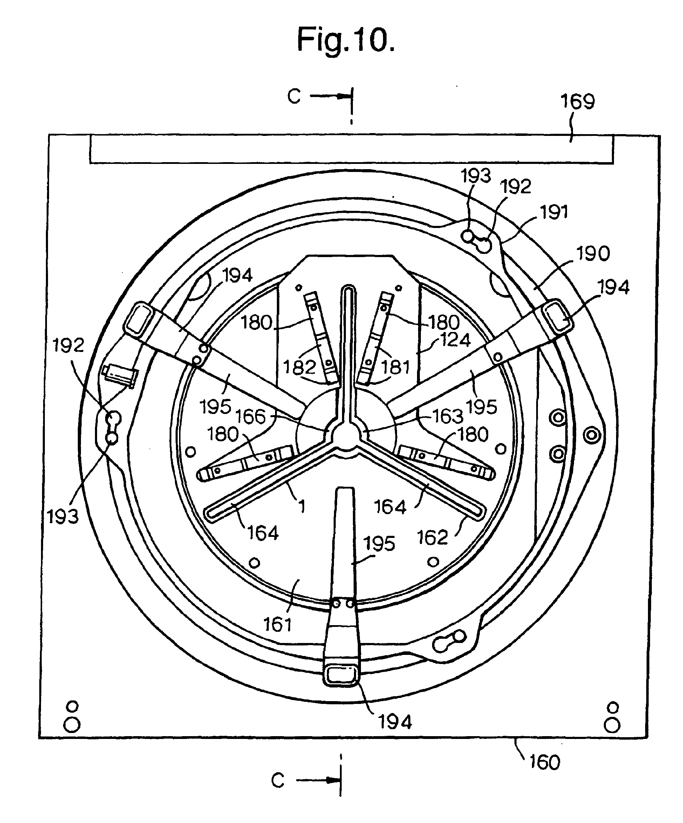

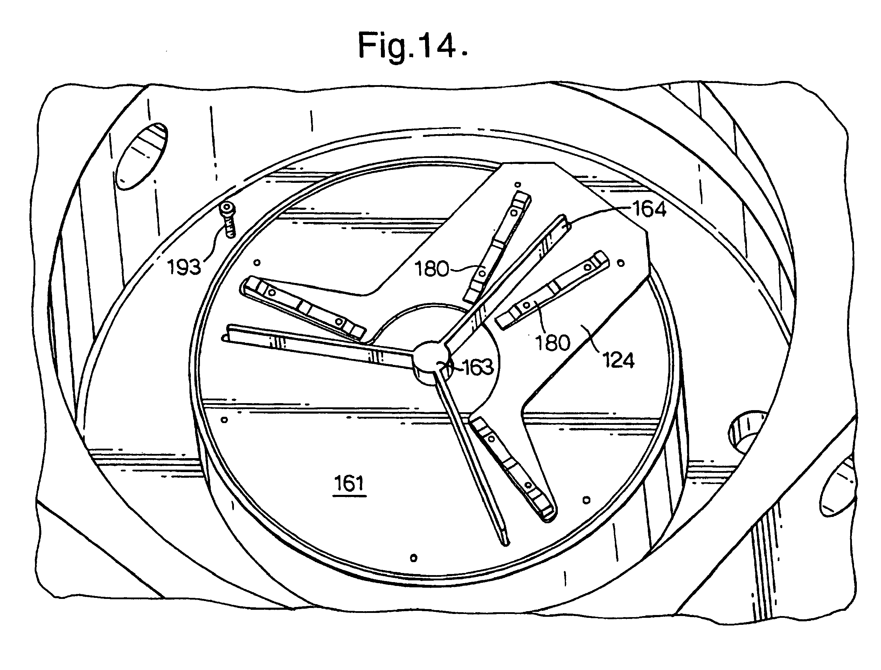

Figures 10 to 14 show a second example of a substrate loading apparatus for a processing chamber according to the present invention. The apparatus shown in these diagrams is substantially the same as the apparatus of Figures 1 to 9 with a number of modifications.

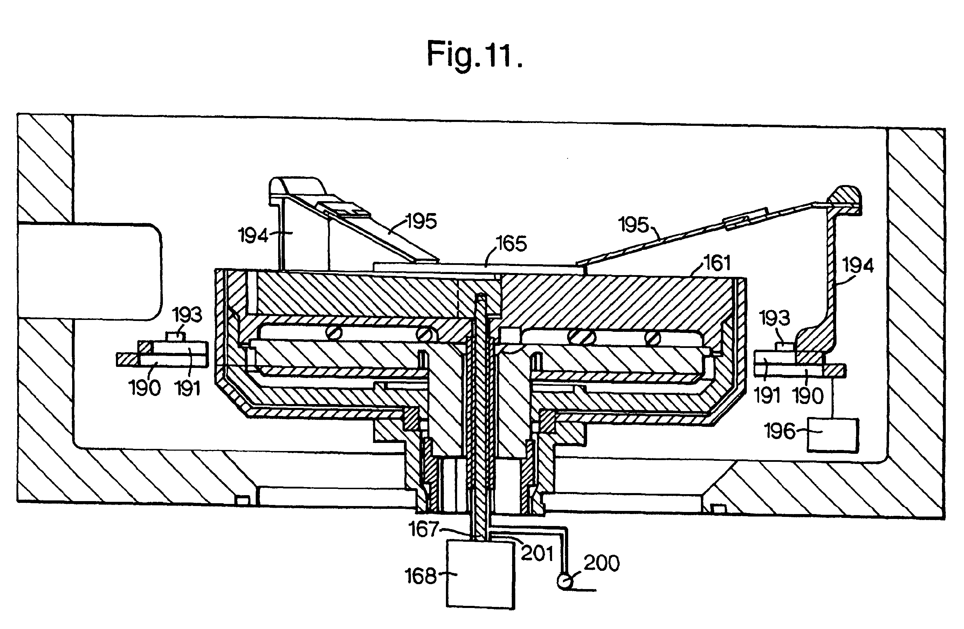

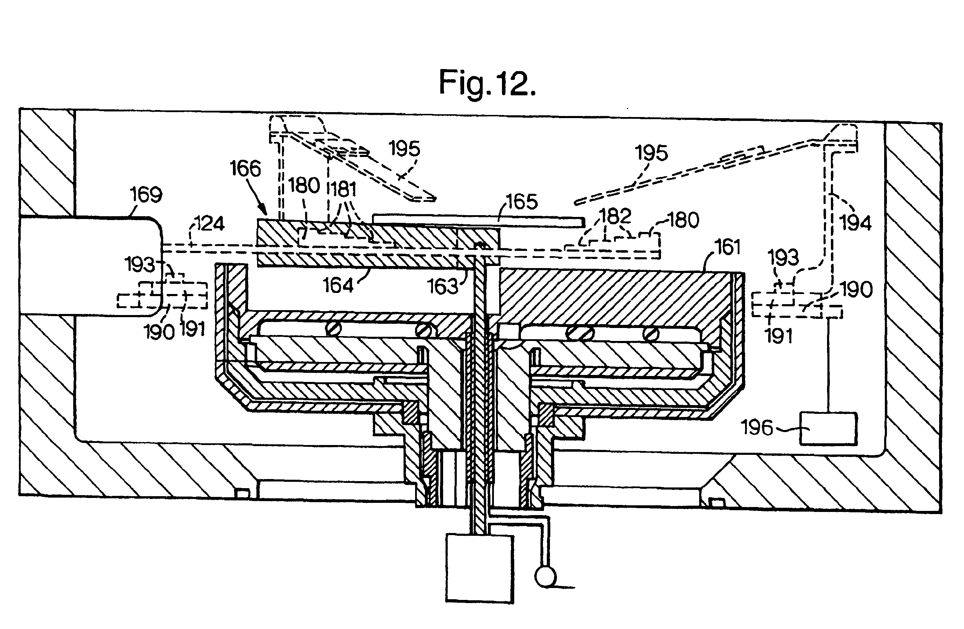

As shown in Figure 10, the apparatus comprises a thin-film processing chamber 160 having a processing surface 161 including an aperture 162. A substrate support 166 is mounted within the aperture, the substrate support including a number of support limbs 164 extending radially outwardly from a central hub 163. As in the previous example, the central hub 163 is coupled via a shaft 167 to an actuator 168 so as to allow the substrate support 166 to move between the retracted position shown in Figure 11 and an extended position shown in Figure 12.

The first modification shown in Figure 10 is the use of a modified substrate mounting 124 which is mounted to a loading arm which can be of any suitable design, such as the loading arm arrangement shown in Figures 6 to 8.

The substrate mounting 124 includes a number of mounting elements 180 which are coupled to the substrate mounting 124 as shown in Figure 10. A side view of the modified substrate mounting 124 is indicated by the dotted lines in Figure 12. As shown, the mounting elements 180 include a number of steps 181 which define a number of mounting surfaces 182. The mounting elements 180 are arranged so that the respective mounting surfaces 182 of the different mounting elements 180 cooperate to support the substrate 165. As will be realised, different sized substrates will be supported on respective different surfaces 182, with lateral motion of the substrate 165 on the support surfaces being constrained by the step 181. As a result, a given size of substrate 165 will always be supported in the same location on the substrate mounting 124. This helps ensure that the substrate 165 will always be loaded onto the processing surface 161 at a desired position.

As in the previous example, the substrate support 166 is moved to the extended position once the substrate mounting 124 has been positioned over the processing surface 161. This causes the substrate 165 to be raised clear of the substrate mounting 124, as shown in Figure 12. The loading arm is retracted so as to move the substrate mounting 124 out of the processing chamber, thereby allowing the substrate support 166 to be lowered. This loads the substrate 165 onto the processing surface 161.

The second modification, which is shown in Figures 10 to 14, is the addition of a clamping system for holding the substrate 165 in position on the processing surface 161. The clamping system comprises a clamp ring 191 which is removably mounted to a support 190. The clamp ring 191 includes three shaped apertures 192 which couple to fixings 193 which are fixably mounted to the support 190. Rotation of the clamp ring 191 causes the fixings 193 to align with the larger end of the aperture 192 so that the clamp ring 191 can be lifted free of the support 190.

Coupled to the clamp ring 191 are three brackets 194 which extend vertically upwards from the ring 191. Two of the brackets 194 are shown in Figure 11. Mounted to each bracket 194 is a resilient clamping member 195 which extends radially inwardly from the bracket 194 so as to contact the processing surface 161. These clamping members are generally formed from a plastic material, or the like, which allows the end of the clamping member to flex with respect to the bracket 194.

The support 190 is coupled to an actuator, which is shown schematically at 196. The actuator 196 allows the support to be moved between an open position, shown by the dotted lines in Figure 12 and a clamping position shown in Figure 11.

In the clamping position, the resilient clamping members 195 contact the edge of the upper surface of the substrate 165 thereby holding the substrate in place on the processing surface 161. As will be understood, the clamping members 195 are designed to flex slightly so as not to crush the substrate whilst still applying sufficient pressure to prevent motion of the substrate 165 with respect to the processing surface 161. When the actuator 196 is activated, this raises the support 190 to the open position shown in Figure 12 so that the resilient clamping members 195 are lifted clear of the substrate 165. This allows the substrate 165 to be raised, as shown in Figure 12.

It will be realised that for different size substrates 165, the clamping members 195 need to be of different lengths. Accordingly, when the size of substrate 165 to be used is altered, the clamping ring 191 is twisted and removed from the support 190 as described above. An alternative clamping ring with different size clamping members 195 is then fitted to the support 190 as required by the alternative size of substrate 165.

The third modification to the apparatus is the addition of a pressure regulator 200 which is coupled to a pipe 201 which surrounds the shaft 167. The pipe 20 is used to allow helium to flow into the aperture 162 under the control of the pressure regulator 200 of the processing surface 161. This is performed to enhance heat transfer between the substrate and the processing surface 161, when the substrate 165 is lowered onto the processing surface.

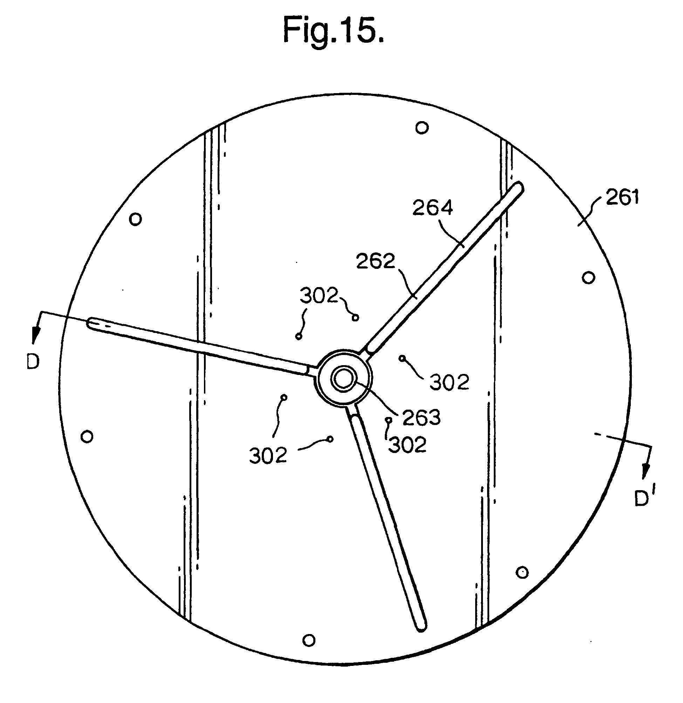

A third example of the present invention is explained using Figure 15. In this example, a modified processing surface 261 is provided for use in a thin film processing chamber. The processing surface 261 includes an aperture 262 and a substrate support 266 mounted within the aperture. The substrate support includes a number of support limbs 264 extending radially outwardly from a central hub 263.

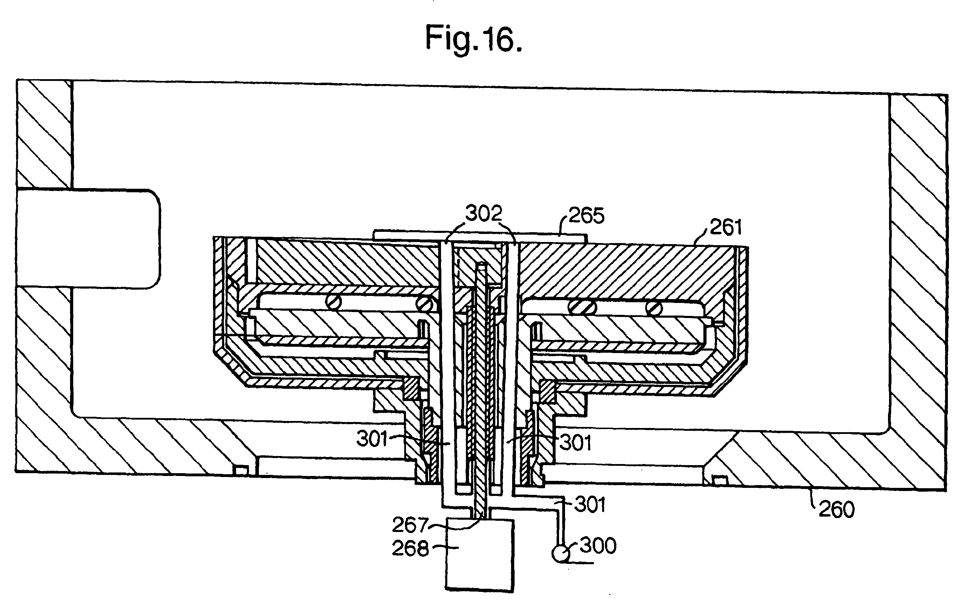

As in the previous examples, the central hub 263 is coupled via a shaft 267 to an actuator 268 so as to allow the substrate support 266 to be moved between a retracted position, which is shown in cross-section in Figure 16, and an extended position (not shown).

As in the previous example, a pressure regulator 300 is provided which is coupled to a pipe 301. In this example, the pipe 301 extends up through the processing surface 261 to a number of inlet holes 302 which are shown in Figure 15. As shown, the inlet holes 302 are circumferentially spaced apart around the aperture 262. In use, a substrate 265 which is to be etched will cover the inlet holes 302, as shown.

As in the previous example, the pressure regulator 300 is used to allow helium to flow into the pipe 301 and through the inlet holes 302. As the film processing chamber 260 is generally maintained at near vacuum pressures, the helium will simply flow into the chamber though the inlet holes 302 causing any air caught between the substrate 265 and the processing surface 261 to be expelled. The inlet holes 302 are positioned away from the aperture 262 to reduce the dissipation of helium through the aperture 262.

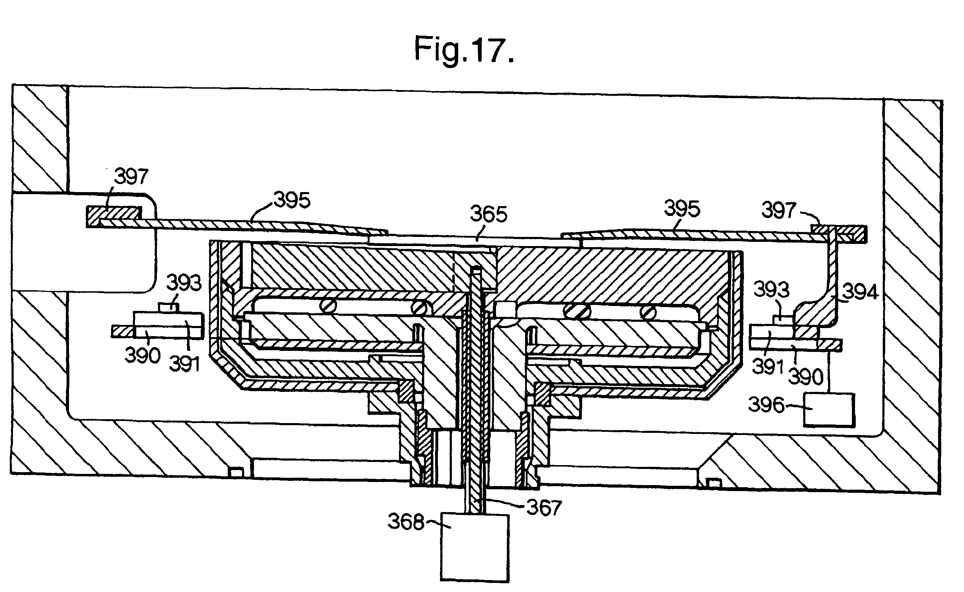

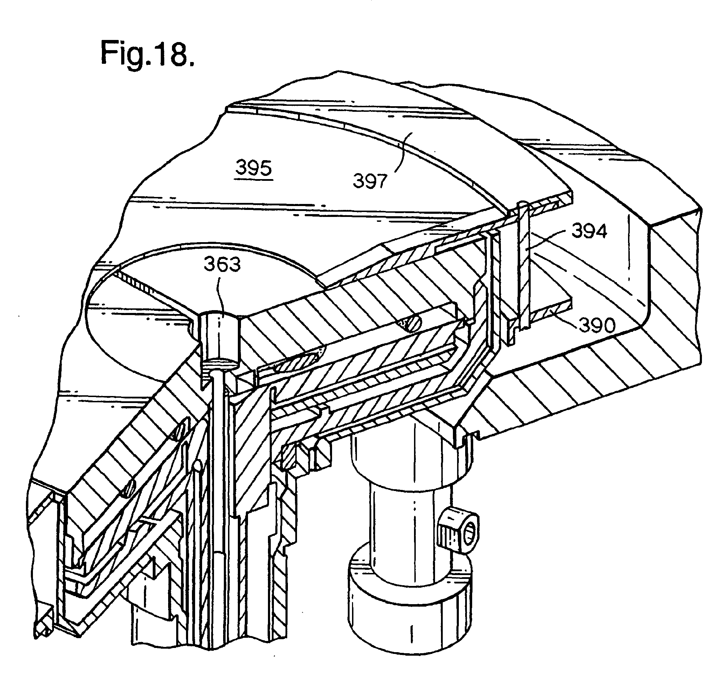

An example of a fourth embodiment of the present invention will now be described with reference to Figures 17 and 18. In this example, the clamping arrangement formed from the clamping members 195, shown for example in Figures 11 and 12, is replaced with an annular clamping arrangement.

Thus, as shown, a thin film processing chamber 360 having a processing surface 361 is provided with an aperture 362. A substrate support 366 is mounted within the aperture, the substrate support including a number of support limbs 264 extending radially outwardly from a central hub 363. The central hub 363 is coupled via a shaft 367 to an actuator 368 so as to allow the substrate support 366 to move between retracted and extended positions, as shown for example in previous embodiments.

In this example, a clamping system is provided for holding the substrate 365 in position on the processing surface 361.

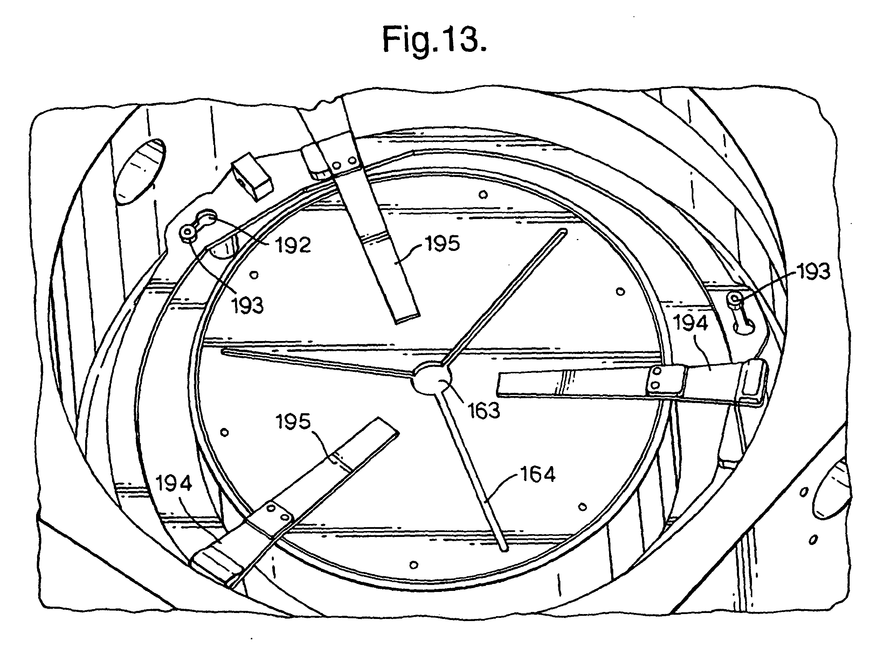

The clamping system comprises a clamp ring 391 which is movably mounted to a support 390. The clamp ring 391 includes three shaped apertures (not shown but similar to the apertures of 192 shown in Figure 13) which couple to fixings 393 which are fixably mounted to the support 390. Rotation of the clamp ring 391 causes the fixings 393 to align with the larger end of the aperture so that the clamp ring 391 can be lifted free of the support 390.

Coupled to the clamp ring 391 are a number of brackets 394 which extend vertically upwards from the ring 391. The brackets are mounted at their upper end to an annular wafer clamp 395 which is held in place by a retaining ring 397.

The wafer clamp 395 extends radially inwardly from the brackets 394 as shown.

In use, the support 390 is coupled to an actuator 396 which allows the support 390 to move between an open position (not shown) and a clamping position shown in Figure 17.

In use, the support 390 is raised, as in the second embodiment to allow a substrate 365 to be positioned on the support surface 361. The actuator 396 is then operated to lower the support 390 into the clamping position. At this time, the wafer clamp 395 contacts the upper surface of the substrate 395 to hold it in place.

Because the wafer clamp 395 is an annulus, this ensures that the clamping pressure is provided around the entire circumference of the substrate 365. This provides a more secure clamping mechanism than the clamping mechanism of the second embodiment shown in Figures 10 to 14. In addition to this, as pressure is exerted evenly around the entire circumference of the substrate 365, this helps prevent the substrate being cracked by differences in pressure along its upper surface.

Again, as in the second embodiment it is possible to use different size of wafer clamp 395 when different sizes of substrate 165 are clamped.

It will be realised by a person skilled in the art that any of the modifications described in the second, third and fourth embodiments may be implemented separately or in any combination. The description of all the modifications within the four examples is for the case of description only and is not intended to be limiting.

## Claims

1. Processing chamber (60) with a processing surface (61) and an apparatus for loading a substrate (65) onto the processing surface, the apparatus comprising a support (66) which cooperates with one or more corresponding apertures (62) in the processing surface so as to be movable between an extended position in which the support can support a substrate above the processing surface, and a retracted position in which the support is located within said one or more apertures and flush with or located below the processing surface, wherein the support comprises a number of limbs (64) extending radially outwardly from a central hub (63), **characterized in that** said limbs extend radially outward at an angle relative to the processing surface, the limbs being configured to contact the edges of different sized substrates in use so as to support the substrate in a support plane substantially parallel to the processing surface, the support plane being provided above the central hub.

2. Processing chamber according to claim 1, wherein each limb defines a continuous support surface extending at an angle relative to the processing surface, each support surface contacting the edges of different sized substrates in use.

3. Processing chamber according to claim 1 or claim 2, further comprising a loading arm having a mounting (24,124) which receives a substrate in use, the loading arm being movable between a retracted position and an extended position in which the mounting and the support cooperate such that, in use, motion of the support to the extended position causes the substrate to be supported by the support, thereby removing the substrate from the mounting.

4. Processing chamber according to claim 3, wherein the mounting is located outside the chamber when the loading arm is in the retracted position.

5. Processing chamber according to claim 3 or claim 4, wherein the mounting comprises a number of mounting elements (180) extending radially outwardly from a central portion, each mounting element including a number of steps (181) defining a number of mounting surfaces (182).

6. Processing chamber according to any of claims 3 to 5, further comprising a drive means for controllably moving the loading arm between the extended and retracted positions.

7. Processing chamber according to any of the preceding claims, further comprising an actuator (68) for controllably moving the support between the extended and retracted positions.

8. Processing chamber according to any of the preceding claims, further comprising a clamp movable between an open position and a clamping position for clamping the substrate to the processing surface.

9. Processing chamber according to claim 8, wherein the clamp comprises an annular clamping element (395) extending radially inwardly from an outer clamping ring (397), the clamping ring being positioned radially outwardly from the processing surface.

10. Processing chamber according to claim 9, the apparatus further comprising a clamp actuator (396) for moving the clamp between the open and clamping positions, the clamping ring being removably mounted to the clamp actuator.

11. Processing chamber according to claim 4, or any of claims 5 to 10 when dependent on claim 4, the apparatus further comprising a controller for controllably moving the support and the loading arm between their respective retracted and extended positions.

12. Processing chamber according to any of the preceding claims, further comprising a loading arm having a mounting (124) which receives a substrate in use, the loading arm being movable between a retracted position in which the mounting is outside the processing chamber and an extended position in which the mounting is inside the processing chamber, wherein the mounting comprises a number of mounting elements (180) extending substantially radially outwardly from a central position, each mounting element including a number of steps (181) defining a number of mounting surfaces (182), and wherein the mounting and the support cooperate such that, in use, with the loading arm in the extended position, motion of the support to the extended position causes the substrate to be supported by the support, thereby removing the substrate from the mounting.

13. Processing chamber according to claim 12, wherein the mounting surfaces of a given step are designed to be used when loading a respective size of substrate.

14. Processing chamber according to claim 13, wherein the mounting is adapted such that in use a substrate positioned on the mounting on a given step (181) will be located substantially over the centre of the processing surface when the loading arm is in the extended position.

15. Processing chamber according to any of the claims 12 to 14, further comprising a drive means for controllably moving the loading arm between the extended and retracted positions.

16. Processing chamber according to any of claims 12 to 15, wherein the loading arm comprises a carriage (25); first drive means (40-42) for driving the carriage with respect to a base (26); and second drive means (29,30,33) which moves with the carriage and cooperates with the base whereby the relative movement between the carriage and the base causes the second drive means to drive the mounting with respect to the carriage.

17. Processing chamber according to claim 16, wherein the carriage is slidably mounted to the base and the mounting is slidably mounted to the carriage.

18. A thin film processing system comprising one or more processing chambers according to any of the preceding claims.

19. A system according to claim 18, wherein the system is a plasma processing system for treatment of semiconductor wafers.

## Revendications

1. Chambre de traitement (60) avec une surface de traitement (61) et un appareil pour charger un substrat (65) sur la surface de traitement, l'appareil comprenant un support (66) qui coopère avec une ou plusieurs ouvertures (62) dans la surface de traitement de façon à être mobile entre une position étendue dans laquelle le support peut supporter un substrat au-dessus de la surface de traitement, et une position rétractée dans laquelle le support est situé dans lesdites une ou plusieurs ouvertures et à niveau avec ou situé sous la surface de traitement, dans lequel le support comprend un certains nombre de bras (64) s'étendant radialement vers l'extérieur depuis un moyeu central (63), **caractérisé en ce que** lesdits bras s'étendent radialement vers l'extérieur avec un angle relatif à la surface de traitement, les bras étant configurés pour entrer en contact avec les bords de substrats de différentes tailles en utilisation de façon à supporter le substrat dans un plan de support sensiblement paroi latérale à la surface de traitement, le plan de support étant placé au-dessus du moyeu central.

2. Chambre de traitement selon la revendication 1, dans laquelle chaque bras définit une surface de support continue s'étendant avec un angle par rapport à la surface de traitement, chaque surface de support entrant en contact avec les bords de substrats de différentes tailles en utilisation.

3. Chambre de traitement selon la revendication 1 ou 2, comprenant en outre un bras de chargement ayant un montage (24, 124) qui reçoit un substrat en utilisation, le bras de chargement étant mobile entre une position rétractée et un position étendue dans laquelle le montage et le support coopèrent de telle manière qu'en utilisation le mouvement du support dans la position étendue fait que le substrat est supporté par le support, enlevant ainsi le substrat du montage.

4. Chambre de traitement selon la revendication 3, dans laquelle le montage est situé à l'extérieur de la chambre quand le bras de chargement est dans la position rétractée.

5. Chambre de traitement selon la revendication 3 ou 4, dans laquelle le montage comprend un certain nombre d'éléments de montage (180) s'étendant radialement vers l'extérieur depuis une partie centrale, chaque élément de montage comprenant un certain nombre de degrés (181) définissant un certain nombre de surfaces de montage (182).

6. Chambre de traitement selon l'une quelconque des revendications 3 à 5, comprenant en outre des moyens d'entraînement pour déplacer de manière contrôlée le bras de chargement entre les positions étendue et rétractée.

7. Chambre de traitement selon l'une quelconque des revendications précédentes, comprenant en outre un actionneur (68) pour déplacer de manière contrôlée le support entre les positions étendue et rétractée.

8. Chambre de traitement selon l'une quelconque des revendications précédentes, comprenant en outre une bride mobile entre une position ouverte et une position de serrage pour serrer le substrat sur la surface de traitement.

9. Chambre de traitement selon la revendication 8, dans laquelle la bride comprend un élément de serrage annulaire (395) s'étendant radialement vers l'intérieur depuis un anneau de serrage extérieur (397), l'anneau de serrage étant positionné radialement vers l'éxtérieur de la surface de traitement.

10. Chambre de traitement selon la revendication 9, l'appareil comprenant en outre un actionneur de bride (396) pour déplacer la bride entre les positions ouverte et de serrage, l'anneau de serrage étant monté de manière amovible sur l'actionneur de bride.

11. Chambre de traitement selon la revendication 4, ou l'une quelconque des revendications 5 à 10 selon la revendication 4, l'appareil comprenant en outre une commande pour déplacer de manière contrôlée le support et le bras de chargement entre leurs positions respectives rétractées et étend ues.

12. Chambre de traitement selon l'une quelconque des revendications précédentes, comprenant en outre un bras de chargement ayant un montage (124) qui reçoit un substrat en utilisation, le bras de chargement étant mobile entre une position rétractée dans laquelle le montage est à l'extérieur de la chambre de traitement et une position étendue dans laquelle le montage est à l'intérieur de la chambre de traitement, dans laquelle le montage comprend un certain nombre d'éléments de montage (180) s'étendant sensiblement radialement vers l'extérieur depuis une position centrale, chaque élément de montage comprenant un certain nombre de degrés (181) définissant un certain nombre de surfaces de montage (182), et dans lequel le montage et le support coopèrent de telle manière que, en utilisation, avec le bras de chargement dans la position étendue, le déplacement du support vers la position étendue fait que le substrat est supporté par le support, enlevant ainsi le substrat du montage.

13. Chambre de traitement selon la revendication 12, dans laquelle les surfaces de montage d'un degré donné sont conçues pour être utilisées quand on charge une taille respective de substrat.

14. Chambre de traitement selon la revendication 13, dans laquelle le montage est adapté de telle manière qu'en utilisation un substrat positionné sur le montage sur un degré donnée (181) est situé sensiblement au-dessus du centre de la surface de traitement quand le bras de chargement est dans la position étendue.

15. Chambre de traitement selon l'une quelconque des revendications 12 à 14, comprenant en outre des moyens d'entraînement pour déplacer de manière contrôlée le bras de chargement entre les positions étendue et rétractée.

16. Chambre de traitement selon l'une quelconque des revendications 12 à 15, dans laquelle le bras de chargement comprend un chariot (25) ; des premiers moyens d'entraînement (40-42) pour entraîner le chariot par rapport à une base (26) ; et des seconds moyens d'entraînement (29, 30, 33) qui se déplacent avec le chariot et coopèrent avec la base moyennant quoi le déplacement relatif entre le chariot et la base fait que les seconds moyens d'entraînement déplacent le montage par rapport au chariot.

17. Chambre de traitement selon la revendication 16, dans laquelle le chariot est monté de manière coulissante sur la base et le montage est monté de manière coulissante sur le chariot.

18. Système de traitement de film fin comprenant une ou plusieurs chambres de traitement selon l'une quelconque des revendications précédentes.

19. Système selon la revendication 18, dans lequel le système est un système de traitement au plasma pour le traitement de puces de semi-conducteur.

## Patentansprüche

1. Behandlungskammer (60) mit einer Behandlungsfläche (61) und einer Vorrichtung zum Einschleusen eines Substrats (65) auf die Behandlungsfläche, wobei die Vorrichtung einen Träger (66) aufweist, der mit einer oder mehreren entsprechenden Öffnungen (62) in der Behandlungsfläche so zusammenwirkt, daß er zwischen einer ausgefahrenen Position, in der der Träger ein Substrat oberhalb der Behandlungsfläche halten kann, und einer eingefahrenen Position, in der der Träger innerhalb der einen oder mehrerer Öffnungen angeordnet ist und mit der Behandlungsfläche abschließt oder unterhalb der Behandlungsfläche angeordnet ist, bewegbar ist, wobei der Träger eine Anzahl von Armen (64) aufweist, die sich von einer zentralen Nabe (63) radial nach außen erstrecken, **dadurch gekennzeichnet, daß** sich die Arme radial nach außen unter einem Winkel relativ zu der Behandlungsfläche erstrecken, wobei die Arme so ausgestaltet sind, daß sie im Gebrauch die Kanten von unterschiedlich großen Substraten berühren, um so das Substrat in einer Stützebene zu tragen, die im wesentlichen parallel zu der Behandlungsfläche liegt, wobei die Stützebene oberhalb der zentralen Nabe vorgesehen ist.

2. Behandlungskammer nach Anspruch 1, worin jeder Arm eine kontinuierliche Stützfläche definiert, die sich unter einem Winkel relativ zur Behandlungsfläche erstreckt, wobei jede Stützfläche im Gebrauch die Kanten von unterschiedlich großen Substraten berührt.

3. Behandlungskammer nach Anspruch 1 oder 2, die weiterhin einen Einschleusearm aufweist, der eine Lagerung (24, 124) hat, die im Gebrauch ein Substrat aufnimmt, wobei der Einschleusearm zwischen einer eingefahrenen Position und einer ausgefahrenen Position bewegbar ist, in der die Lagerung und der Träger so zusammenwirken, daß im Gebrauch die Bewegung des Trägers in die ausgefahrene Position bewirkt, daß das Substrat durch den Träger getragen wird, wodurch das Substrat von der Lagerung entfernt wird.

4. Behandlungskammer nach Anspruch 3, worin die Lagerung außerhalb der Kammer angeordnet ist, wenn der Einschleusearm in der eingefahrenen Position ist.

5. Behandlungskammer nach Anspruch 3 oder 4, worin die Lagerung eine Anzahl von Lagerelementen (180) aufweist, die sich von einem mittleren Abschnitt radial nach außen erstrecken, wobei jedes Lagerelement eine Anzahl von Stufen (181) aufweist, die eine Anzahl von Lagerflächen (182) bilden.

6. Behandlungskammer nach einem der Ansprüche 3 bis 5, die weiterhin aufweist eine Antriebseinrichtung zum gesteuerten Bewegen des Einschleusearms zwischen der ausgefahrenen und der eingefahrenen Position.

7. Behandlungskammer nach einem der vorhergehenden Ansprüche, die weiterhin einen Aktuator (68) zum gesteuerten Bewegen des Trägers zwischen der ausgefahrenen und der eingefahrenen Position aufweist.

8. Behandlungskammer nach einem der vorhergehenden Ansprüche, die weiterhin eine Klammer aufweist, die bewegbar ist zwischen einer offenen Position und einer klemmenden Position zum Klemmen des Substrats auf der Behandlungsfläche.

9. Behandlungskammer nach Anspruch 8, worin die Klammer ein ringförmiges Klammerelement (395) aufweist, das sich von einem äußeren klemmenden Ring (397) radial nach innen erstreckt, wobei der klemmende Ring radial auswärts von der Behandlungsfläche positioniert ist.

10. Behandlungskammer nach Anspruch 9, wobei die Vorrichtung weiterhin einen Klammeraktuator (396) aufweist zum Bewegen der Klammer zwischen der offenen und der klemmenden Position, wobei der klemmende Ring entfernbar an dem Klammeraktuator montiert ist.

11. Behandlungskammer nach Anspruch 4 oder jedem der Ansprüche 5 bis 10, wenn sie von Anspruch 4 anhängen, wobei die Vorrichtung weiter aufweist eine Steuereinrichtung zum gesteuerten Bewegen des Trägers und des Einschleusearms zwischen ihren jeweiligen eingefahrenen und ausgefahrenen Positionen.

12. Behandlungskammer nach einem der vorherigen Ansprüche, die weiterhin aufweist einen Einschleusearm, der eine Lagerung (124) aufweist, die im Gebrauch ein Substrat aufnimmt, wobei der Einschleusearm bewegbar ist zwischen einer eingefahrenen Position, in der die Lagerung außerhalb der Behandlungskammer ist, und einer ausgefahrenen Position, in der die Lagerung innerhalb der Behandlungskammer ist, wobei die Lagerung eine Anzahl von Lagerelementen (180) aufweist, die sich von einem mittleren Abschnitt im wesentlichen radial nach außen erstrecken, wobei jedes Lagerelement eine Anzahl von Stufen (181) aufweist, die eine Anzahl von Montageflächen (182) bilden, und worin die Lagerung und der Träger so zusammenwirken, daß im Gebrauch, wenn der Einschleusearm in der ausgefahrenen Position ist, die Bewegung des Trägers in die ausgefahrene Position bewirkt, daß das Substrat durch den Träger unterstützt wird, wodurch das Substrat von dem Lager entfernt wird.

13. Behandlungskammer nach Anspruch 12, worin die Lagerflächen einer gegebenen Stufe so gestaltet sind, daß sie verwendet werden, wenn eine jeweilige Größe des Substrats eingeschleust wird.

14. Behandlungskammer nach Anspruch 13, worin die Lagerung so angepaßt ist, daß im Gebrauch ein Substrat, das auf der Lagerung auf einer gegebenen Stufe (181) positioniert ist, im wesentlichen über dem Zentrum der Behandlungsfläche angeordnet sein wird, wenn der Einschleusearm in der ausgefahrenen Position ist.

15. Behandlungskammer nach einem der Ansprüche 12 bis 14, die weiterhin eine Antriebseinrichtung zum gesteuerten Bewegen des Einschleusearms zwischen der ausgefahrenen und der eingefahrenen Position aufweist.

16. Behandlungskammer nach einem der Ansprüche 12 bis 15, worin der Einschleusearm aufweist einen Schlitten (25), erste Antriebseinrichtungen (40-42) zum Antreiben des Schlittens relativ zu einer Basis (26), und zweite Antriebseinrichtungen (29, 30, 33), die sich mit dem Schlitten bewegen und mit der Basis zusammenwirken, wobei die relative Bewegung zwischen dem Schlitten und der Basis bewirkt, daß die zweiten Antriebseinrichtungen die Lagerung relativ zum Schlitten bewegen.

17. Behandlungskammer nach Anspruch 16, worin der Schlitten gleitend an der Basis montiert ist und die Lagerung gleitend an dem Schlitten montiert ist.

18. Dünnfilmbearbeitungssystem, das eine oder mehrere Bearbeitungskammern nach einem der vorhergehenden Ansprüche aufweist.

19. System nach Anspruch 18, worin das System ein Plasmabehandlungssystem zur Behandlung von Halbleiterwafern ist.
